# EUROPEAN PATENT SPECIFICATION

(11) **EP 1 646 151 B1**
(45) Date of publication and mention of the grant of the patent: **11.07.2018**
(21) Application number: 04735485.7
(22) Date of filing: 31.05.2004
(51) Int. Cl.: H03M 1/08, H03M 1/12, H03M 1/66, H03M 3/00

(54) **METHOD FOR RESAMPLING AT THE TRANSMISSION OF A DIGITAL SIGNAL WITH DIGITAL BAND TRANSLATION**
VERFAHREN ZUM RESAMPLING BEI DER ÜBERTRAGUNG EINES DIGITALSIGNALS MIT DIGITAL-BAND-ÜBERSETZUNG
PROCEDE DE REECHANTILLONNAGE DANS LA TRANSMISSION D'UN SIGNAL NUMERIQUE AVEC TRANSLATION DANS LA BANDE NUMERIQUE

(30) Priority: 30.05.2003 ES 200301288
(43) Date of publication of application: 12.04.2006
(73) Proprietor: Marvell Hispania S.L., Madrid (ES)
(72) Inventor: BLASCO CLARET, Jorge Vicente, E-46020 Valencia (ES); RIVEIRO INSUA, Juan Carlos, E-46019 Valencia (ES); IRANZO MOLINERO, Salvador, E-46117 BETERA (Valencia) (ES); GARCIA SAN JOSE , Aitor, E-46019 Valencia (ES)
(74) Representative: Grünecker Patent- und Rechtsanwälte PartG mbB
(86) International application number: PCT/ES2004/000224
(87) International publication number: WO 2004/107584

(56) References cited:
- EP-A1- 1 389 835
- EP-A2- 0 289 401
- EP-A2- 0 794 621
- EP-A2- 0 794 621
- CA-A1- 2 448 106
- US-A- 5 255 220
- US-A- 5 365 468
- US-B1- 6 411 653
- US-B2- 6 462 682
- ERUP L ET AL: "INTERPOLATION IN DIGITAL MODEMS - PART II: IMPLEMENTATION AND PERFORMANCE", IEEE TRANSACTIONS ON COMMUNICATIONS, IEEE SERVICE CENTER, PISCATAWAY, NJ. USA, vol. 41, no. 6, 1 June 1993 (1993-06-01), pages 998-1008, XP000392975, ISSN: 0090-6778, DOI: 10.1109/26.231921

## Description

### OBJECT OF THE INVENTION

As stated in the title of this specification, the present invention refers to a procedure for resampling in transmission and reception of a digital signal with digital band translation which permits correction of the frequency error introduced by digital-analog and analog-digital converters used in telecommunications systems.

The procedure of the invention simplifies the electronics necessary for carrying out resampling in band-pass signals.

### BACKGROUND TO THE INVENTION

In the majority of telecommunications systems, the signal transmitted is sampled in reception by an analog-digital converter using a time constant sampling frequency. As this sampling frequency is not exactly equal to the transmission frequency, it is necessary to interpolate the received signal in order to obtain the samples which would be received if the two frequencies were equal, and in this way be able to demodulate the previously transmitted data correctly.

Gardner in "Interpolation in Digital Modems: Part I: Fundamentals. IEEE Transactions on Communications, Vol 41, N° 6, June 1993" presents the fundamentals of time synchronization by means of interpolation techniques, while in "Interpolation in Digital Modems: Part II: Implementation and Performance. IEEE Transactions on Communications, Vol 41, N° 6, June 1993" he conducts a study of the implementation of interpolators by means of digital filters.

The interpolation structure described in the cited references displays various drawbacks. Standing out among the main ones is the excessive complexity and enormous size of the interpolation filters needed for their application in resampling of band-pass signals. Another of the drawbacks consists of the fact that the working frequency of the filters is so high that their implementation is very costly.

The invention forming the object of the patent proposes a variation on the interpolation structure which facilitates its implementation, reducing the complexity of the filters and lowering their working frequency. Also, the resampling is done not just in reception but also in transmission.

It can be pointed out that during the course of the description the acronym CORDIC is used (Coordinate Rotation Digital Computer), which refers to an algorithm for the calculation of mathematical functions optimized for its physical implementation. This algorithm is known in the state of the art and its explanation has not been included in this proforma. Also, the initials DAC and ADC are used for referring to digital-analog and analog-digital converters, while the initials OFDM refer to orthogonal frequency division multiplexing.

CA 2 448 106 A1 discloses a downlink synchronisation method for a point-to-multipoint system with OFDM modulation. The invention disclosed in this document relates to a system that is suitable for bidirectional communication via the electrical network between a headend and numerous users. Said invention can be used for both time and frequency synchronisation of multiple users in an OFDM (Orthogonal Frequency Division Multiplexing) multi-carrier communication system. The method disclosed in this document is characterised in that it consists in generating synchronisation sequences using two identical synchronisation symbols which are transmitted periodically from the headend equipment by means of the downlink to the users. The sampling frequency can then be determined and corrected and, simultaneously, the moment at which the OFDM symbol starts can be determined, such that the samples of the signal received by each user match those used in the transmission.

EP 0 289 401 A2 relates to a digital demodulator for frequency-division-multiplexed signals. This document discloses an improved digital demodulator capable of demodulating a frequency multiplexed input signal. The frequency division multiplexed input signal is sampled in an analog-to-digital converter. The samples are translated by mixing with base band frequency signals to yield real and imaginary values corresponding to phase information in the original modulation signals. After translation, the translated samples are filtered in real and imaginary digital filters. After filtering, the original modulation information is recovered by analysis of the position of vectors in the complex plane represented by the real and imaginary values. In the preferred embodiment of the invention disclosed in this document, a successive approximation technique is used to determine the angle of the vectors to the real axis. Low pass output filtering may be employed after recovery of the modulation signal for improvements in signal to noise ratio. In the preferred embodiment, the translation is performed by multiplying the input samples by digital values corresponding to sine and cosine values of local oscillator signals at base band frequencies. Preselect filtering may be employed prior to translation to decimate the input samples where possible to reduce subsequent processing requirements. In the preferred embodiment, the unit is operated in a first initialization mode in which a microprocessor supplies appropriate filter coefficients corresponding to the frequencies of the channels to be demodulated. Thereafter, the microprocessor does not directly control supply of samples or coefficients to the filters for evaluation. Very high data rates are thus made possible.

EP 0 794 621 A2 relates to a sigma-delta digital-to-analog conversion system and process through reconstruction and resampling. This document discloses a conversion system and method for converting between digital and analog data signals. The conversion system comprises a signal input line for each digital data signal, a reconstructor-resampler unit for each digital data signal, a combiner, a modulator, a digital-to-analog converter, and a signal output line. Each signal line input couples to the respective reconstructor-resampler unit for the digital data signal. Each reconstructor-resampler unit then couples to a combiner which couples to a modulator. The modulator couples to the digital-to-analog converter that couples to the signal output line from which an analog output signal is produced. The reconstructor-resampler comprises a sampling member coupled to the signal line input and a polynomial interpolator member coupled to the sampling member and the modulator. Also, the modulator operates at a predetermined, or fixed, frequency regardless of the sampling frequency of the digital data signal. The steps of the conversion method include inputting a digital data signal having a sampling frequency, reconstructing and resampling the digital data signal to generate a resampled data signal, performing noise-shaping on the resampled data signal to generate a x-bit data signal from a modulator operating at a predetermined frequency regardless of the sampling frequency of any of the digital data signals, and converting the x-bit data signal to an analog data signal. In addition, an analog-to-digital conversion system and method is disclosed that comprises a signal line input, a decimator, a reconstructor-resampler a signal output line, and a modulator operating at a predetermined frequency to convert an analog data signal to a digital data signal.

### DESCRIPTION OF THE INVENTION

It is the object of the present invention to provide a flexible method for resampling of digital signals.

This object is solved by the subject matter of the independent claims.

Preferred embodiments are defined by the dependent claims.

In order to achieve the objectives and avoid the drawbacks stated in the above sections, the invention consists of a procedure for resampling in transmission and reception of a digital signal with digital band translation, which selectively comprises processing in transmission, in reception or a combination of both.

In reception, the processing comprises the sampling of the signal in reception by means of an analog-digital converter (ADC), a band translation of the signal and a processing of the signal in the time domain. Due to the fact that most communications channels are band-pass channels, the information is transmitted in band-pass so that in reception, following the analog-digital conversion (ADC), a translation of the digital signal to base-band is performed. The invention provides for an adjustment to be made in reception to the band translation frequency of the digital signal in the process of conversion of the signal to base-band, and following that conversion the signal is decimated in order to reduce the sampling frequency and eliminate replicas. Following decimation of the signal in base-band, the signal is resampled in order to obtain the desired samples.

The processing of the signal carried out in reception following the resampling is done continuously and the blocks located after the resampler must be capable of absorbing the variations in the output frequency of the signal from the resampler, for which an overdimensioning of the hardware is carried out.

In the processing in transmission, the base-band signal is resampled. Following the resampling, the signal is interpolated in order to increment the sampling frequency. Later on, the signal is translated in frequency in order to obtain a band-pass signal and supply it to the digital-analog converter (DAC) where the signal is converted into an analog signal for its transmission. In the translation process the invention provides for the adjustment of the band translation frequency of the digital signal.

As the number of samples exiting the resampler in transmission is variable in time, a memory has been introduced after the resampler which is in charge of absorbing all the samples of the resampling block and supplying them to the interpolation block with a fixed cadence. In other words, the speed with which the samples are introduced into the memory is variable and the speed of reading the memory is fixed.

So that the operation of the memory in transmission can be robust, the reading and writing indices will be reset to their initial valueswhen there is no transmission or just zeros are being transmitted.

On the other hand, when the speed of writing is higher than that of reading, the memory will start to be read immediately after the first writing.

When the speed of reading is higher than that of writing, a certain number of samples will have to have been written before starting to read the memory, said number of samples being calculated on the basis of the resampling factor applied and of the duration of the transmission.

The calculation of the dimensions of the memory is done taking as reference the maximum transmission time and the maximum resampling time, in such a way that no sample that is introduced into that memory is lost.

Furthermore, in order to carry out the translations from band-pass to base-band in reception and from base-band to band-pass in transmission, it is necessary to calculate at least one sine and one cosine, for which a CORDIC is used.

In an embodiment of the invention for reducing the complexity of the resampler, both in transmission and in reception, the signal is interpolated by an integer number prior to its application to the input of the resampler, while at its output the samples will be decimated by the same factor.

Standing out among the most important advantages of this invention is the simplification of the structure of filters needed for resampling a band-pass signal as well as a reduction in the working frequency of the filters in order to facilitate their implementation, the possibility of carrying out resampling in transmission and not just in reception, and which, thanks to the possibility of using the CORDIC algorithm with the procedure of the invention, an implementation of the translation in frequency is achieved which permits great flexibility when it comes to situating the signal in the band that is of interest.

Below, in order to facilitate a better understanding of this specification and forming an integral part thereof, some figures are included in which the object of the invention has been represented in a manner that is illustrative rather than limiting.

### BRIEF DESCRIPTION OF THE FIGURES

**Figure 1****.-** Schematically represents a block diagram which carries out the resampling in reception.
**Figure 2****.-** Schematically represents a block diagram which carries out the resampling in transmission.
**Figure 3****.-** Schematically represents the memory which is located after the resampler in transmission with the reading and writing indices.
**Figure 4****.-** Represents an implementation of the resampling block with interpolation and decimation.

### DESCRIPTION OF AN EXAMPLE OF EMBODIMENT OF THE INVENTION

Given below is a description of an example of the invention, making reference to the numbering adopted in the figures.

In the majority of communications systems, the signal is transmitted in band-pass, in other words occupying a range of frequencies that does not include the frequency zero. In order to facilitate the implementation of the necessary electronics for transmitting and receiving the signal, this signal is internally processed in base-band, in other words, in a range of frequencies that includes zero, and it is then translated to band-pass in transmission. In reception the process is carried out in reverse.

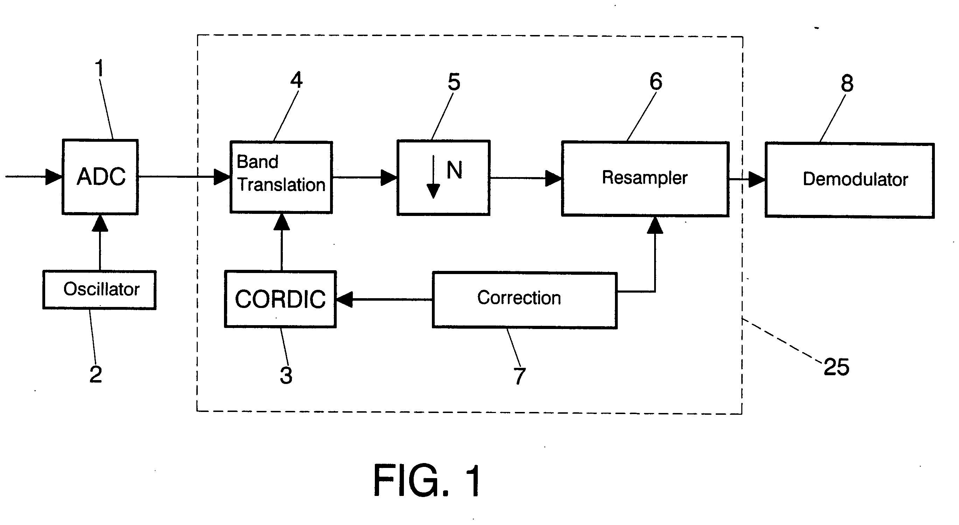

Moreover, in digital communications systems there is always an error between the sampling frequency of the converters, DAC and ADC, used in transmission and reception, respectively. If this error is greater than that which can be permitted by the telecommunication system to which it is applied, then a correction needs to be made, and one of the techniques that can be used is resampling, which consists of obtaining, from a sequence of samples of given instants of time, the samples corresponding to other instants of time. The process of resampling in reception in this example of embodiment can be seen in figure 1 as the set of blocks (25).

This resampling is normally done directly with the band-pass signal after sampling the reception signal by means of an ADC (1), in other words, directly using a resampler block (6), therefore the electronics that is used has to function at the same frequency generated by the oscillator (2) of the ADC converter, and the resampling filters have to have sufficient bandwidth in order not to distort the signal. Instead of using a resampler block (6) directly, the procedure of the invention uses a set of blocks (25) in order to achieve the resampling of the signal, with the advantages stated above. In transmission, the process is similar but the resampling block (16) conventionally used is replaced by the set of blocks (26) in order to carry out the resampling following the procedure of the invention.

In the case of band-pass signals, the system is being overdimensioned because it is working at much higher frequencies than those which would be used if it were working in base-band. Therefore, in reception it is better to carry out the translation to base-band by means of a band translation block (4) directly after the ADC (1). In this example of embodiment, the block (4) corresponds to two multipliers, one of the signal with sine and the other with cosine. As will be described later on, in transmission a band translation block (20) is also used, which is carried out in a similar way, though adding an adder. This frequency translation is not fixed since it depends on the error introduced in the converters, so it has to be adjusted depending on the error that is being corrected. After the frequency translation, the invention performs a decimation (5) of the signal by an integer number, N, in order to reduce the sampling frequency at the decimator output and eliminate the replicas appearing with the band translation, and after that the resampling of the signal is carried out. The resampling block (6) is known in the state of the art and it can be carried out in different ways like those described in part II of the article referenced in the background. By working at a lower frequency and the fact that it depends on the decimation factor, N, the design and the embodiment of the resampling filters become simpler. Also appearing in figure 1 is a block (7) which is responsible for determining the frequency correction to apply and which, as has been explained, affects the translation to base-band, by means of varying the translation frequency to base-band via a CORDIC (3), and also affects the resampling block (6) which, as has been said, is known in the state of the art and which obtains digital samples at its output as if the analog signal equivalent to the digital signal at its input had been sampled with a frequency different to that used for sampling the signal at its input.

The frequency of the samples at the output from the resampling block (6) is different from the input due to the applied correction (7), and the signal processing blocks, among which the first of them is a demodulator (8), located after the resampler must be capable of absorbing this variation. This is especially important if the processing cannot ever be stopped, as is the case with a synchronization block, since the frequency of the samples can be slightly greater than the frequency of the clock used by those synchronization blocks, which compels the latter to be overdimensioned. In other cases, the processing is not continuous, as in DFT (Discrete Fourier Transform) used in the demodulation of an OFDM signal, and the variation is absorbed without any major consequences. If the frequency of samples at the output of the resampler is less than at its input, then there is no problem in stopping the demodulator (8) when there are no samples available at its input.

The resampling of the signal can also be done in transmission in such a way that the receiver receives the same samples as it would obtain in the event of it itself carrying out the resampling. Similarly, the resampling can be done simultaneously in transmission and reception in such a way that between the two processes the error introduced by the converters is corrected.

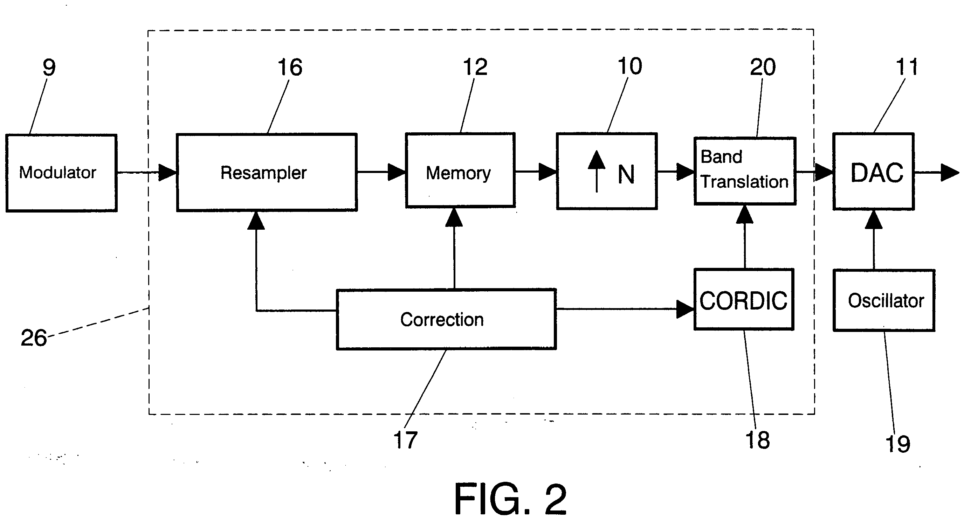

The resampling in transmission can be done in accordance with figure 2, in which the samples to transmit come from a modulator (9) and pass to the resampler block (16). The signal is then interpolated (10) by an integer number N in order to increment the sampling frequency and the signal is translated to band-pass thanks to the translation block (20), already mentioned earlier. Finally, the samples of the band-pass signal are passed to a DAC converter (11). A transmission correction block (17) determines the correction to be applied in the resampler and in the band translation, in a way similar to how this was done in reception. Moreover, this figure also shows the block (19) which represents the oscillator which provides the frequency for the DAC and the block (18) which represents a CORDIC circuit. In another embodiment of the invention, if the transmission and reception are done at different moments, in other words, if a time division is made of the use of the channel, then certain blocks of the system can be reused, for example, using the same CORDIC block for (3) and (18), one translation block for (4) and (20), one resampling block for (6) and (16), one correction block for (7) and (17), and one oscillator (19) and (2), with the functioning of the blocks being adjusted to the transmission and reception periods of the signals.

Also appearing in figure 2 is a memory (12) in which the resampler writes its output samples and from where the interpolator reads them. Both operations are conducted with circular pointers (13 and 14), in other words, when the last position of the memory is reached the first one is then continued with. The function of this memory is to absorb the difference in speed between the output of samples from the resampler and the input into the interpolator.

In the majority of communications systems there are pauses in transmission since resynchronization has to be carried out periodically, the channel has to be estimated, etc. These pauses can be used to empty the content of the memory and reinitiate the values of the pointers. Once the memory has been emptied zeros can be transmitted until it is functioning again.

In resampling in transmission, as occurred in reception, there are two cases that can occur depending on the sign of the correction to make. Sometimes the sampling frequency in reception will be lower than that of transmission and so the resampling procedure in transmission has to generate more samples that those presented to it at the input. In that case the speed of writing in the memory will be greater than that of reading, and therefore it will be possible to read immediately after the first writing.

In other cases, the sampling frequency in reception is greater than that of transmission which means that the resampling procedure in transmission writes the samples in the memory slower than they are read, in which case it waits for the writing pointer (14) to reach a defined position before starting to read. This value is calculated by the corrector block (17) on the basis of the applied correction and the duration of the transmission. Another less optimum implementation waits for the memory to become full before starting to read.

In both cases the block (17) is what determines the functioning of the memory depending on the correction to be made, as shown in figure 2.

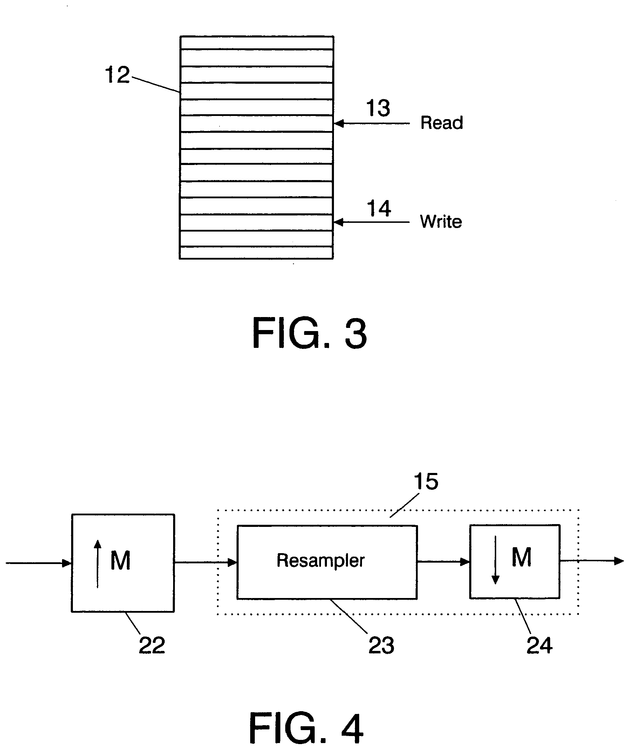

In figure 3, a representation can be observed of the memory and its reading and writing pointers. In order for the reading pointer (13) not to get ahead of the writing pointer (14) under any circumstances, the size of the memory has to be calculated taking into account the maximum duration of a transmission and the maximum applied correction.

For the band translation by means of the translation block (4) or (20), a sine and a cosine of a specific frequency need to be generated. Given that the procedure carries out adjustments in this translation frequency, an efficient algorithm needs to be used for calculating the sine and cosine of variable angles, since the frequency adjustment is done varying the angle increment to be applied in each sample. To achieve this, a CORDIC algorithm is used which calculates the sine and cosine of any angle. To carry out the frequency translation the samples of the signal are multiplied (4) or (20) by the sine and cosine of an angle. This angle increases in modulus 360 degrees in each sample and it is by means of the variation of this angle increment made by the corrector block (7) or (17) that the adjustment in the translation frequency is carried out.

In both transmission and reception, the resampling filters have to have a sufficient bandwidth in order not to distort the signal and not to affect the quality of the communication. Depending on the bandwidth of the signal and on the sampling frequency, it could occur that the implementation of these filters is excessively complex in terms of number of operations or even that it is not possible to obtain a filter that meets the specifications. Moreover, in most communications systems it is necessary that the channel does not vary during the transmission of a symbol, something that is very important in systems using OFDM modulation. In the embodiment of the resampling filters the response of the filter varies lightly in each sample owing to the actual interpolation, this variation being greater for frequencies close to the rejection band of the filter, so it could affect the signal in those frequencies. As can be seen in figure 4 and in the description given earlier, in both transmission and reception it could be a better option to carry out an interpolation by a fixed factor M (22) prior to resampling (23) and then decimating by M (24) later on. The resampler blocks (6) and (16) can be replaced by the unit consisting of interpolator (22), resampler (23) and decimator (24) shown in this figure. In this way the maximum digital frequency of the signal will be divided by M and the specifications of the resampling filter will be simpler to produce, even though it has to function at a frequency M times higher. One of the advantages of this implementation is that decimating by M after the resampling merely consists of taking one out of every M samples since there is no replica of the signal to filter, in other words, there is no additional calculation. Furthermore, it is not necessary to calculate the samples that are eliminated, so the implementation of the resampling block (6), (16) or (23) can be simplified, as represented in figure 4 by means of the block (15) which groups the resampler and the decimator. By simplifying the resampling filter, a more optimum solution can be obtained in terms of number of operations to perform by means of using this structure with interpolation and resampling than in the case of using a resampling structure directly.

## Claims

1. A method for correcting an error between a sampling frequency at transmission and a sampling frequency at reception of a digital signal in a telecommunication system, wherein the digital signal is processed in time domain, the method comprising at transmission side the steps of:
receiving a digital signal comprising samples with a sampling frequency;
resampling (16) the digital signal in order to obtain a resampled signal, wherein a frequency of the resampled signal is different from the sampling frequency, wherein the digital signal is in base-band, and wherein the resampling is used for a correction, wherein the correction is a correction of an error between the sampling frequency at reception and the sampling frequency at the transmission;
writing (12) the output samples from the resampling to a memory, wherein a writing speed to the memory is variable, and wherein a reading speed from the memory is fixed;
interpolating (10) the stored resampled signal from the memory by an integer number N in order to increment the sampling frequency;
translating (20) the interpolated signal to pass-band, wherein the translating comprises performing an adjustment to a translation frequency, wherein the translating is performed by multiplying samples of the interpolated signal by a sine and a cosine of an angle, and wherein the adjustment of the translation frequency is performed by varying an increment of the angle via a coordinate rotation digital computer, CORDIC; and
converting (11) the pass-band signal into an analog signal by a digital-analog converter, DAC,
wherein a transmission correction bock (16) determines the correction to be applied to the resampling and to the translating, and wherein the transmission correction block varies the translation frequency via the CORDIC.

2. The method of claim 1, wherein writing (14) and reading (13) indexes of the memory (12) are reinitiated when there is no transmission or when just zeros are being transmitted.

3. The method of claim 1, wherein following a first writing (14) in the memory (12), reading (13) is immediately started when the writing speed is greater than the reading speed.

4. The method of claim 1, wherein a certain number of samples are written (14) in the memory (12) before starting to read (13) them when the writing speed is less than the reading speed, said number of samples being calculated from an applied resampling factor and a duration of the transmission.

5. The method of claim 1, wherein a size of the memory (12) is calculated from a maximum transmission time and the maximum resampling factor.

6. The method of claim 1, wherein another interpolation (22) is performed by an integer number M prior to the resampling (16), and wherein the output samples of the resampling are decimated (24) by the integer number M.

7. A communication system comprising means configured to perform the method of claim 1.

8. The communication system of claim 7, further configured to perform the method of any one of claims 2 to 6.

## Patentansprüche

1. Verfahren zum Korrigieren eines Fehlers zwischen einer Abtastfrequenz bei der Übertragung und einer Abtastfrequenz beim Empfang eines digitalen Signals in einem Telekommunikationssystem, wobei das digitale Signal im Zeitbereich verarbeitet wird, wobei das Verfahren auf der Übertragungsseite die folgenden Schritte umfasst:
Empfangen eines digitalen Signals, das Abtastwerte mit einer Abtastfrequenz umfasst;
Neuabtasten (16) des digitalen Signals, um ein neuabgetastetes Signal zu erhalten, wobei eine Frequenz des neuabgetasteten Signals von der Abtastfrequenz abweicht, wobei das digitale Signal im Basisband ist, und wobei das Neuabtasten für eine Korrektur verwendet wird, wobei die Korrektur eine Korrektur eines Fehlers zwischen der Abtastfrequenz beim Empfang und der Abtastfrequenz bei der Übertragung ist;
Schreiben (12) der ausgegebenen Abtastwerte vom Neuabtasten in einen Speicher, wobei eine Schreibgeschwindigkeit in den Speicher variabel ist, und wobei eine Lesegeschwindigkeit aus dem Speicher festgelegt ist;
Interpolieren (10) des gespeicherten neuabgetasteten Signals aus dem Speicher um eine ganze Zahl N, um die Abtastfrequenz zu erhöhen;
Übersetzen (20) des interpolierten Signals in das Durchlassband, wobei das Übersetzen ein Durchführen einer Anpassung an eine Übersetzungsfrequenz umfasst, wobei das Übersetzen durch Multiplizieren von Abtastwerten des interpolierten Signals mit einem Sinus und einem Kosinus eines Winkels durchgeführt wird, und wobei die Anpassung der Übersetzungsfrequenz durchgeführt wird, indem ein Inkrement des Winkels über einen Coordinate Rotation Digital Computer, CORDIC, variiert wird; und
Umwandeln (11) des Durchlassbandsignals in ein analoges Signal durch einen Digital-Analog-Wandler, DAC,
wobei ein Übertragungskorrekturblock (16) die Korrektur bestimmt, die auf das Neuabtasten und das Übersetzen anzuwenden ist, und wobei der Übertragungskorrekturblock die Übersetzungsfrequenz über den CORDIC variiert.

2. Verfahren nach Anspruch 1, wobei Schreiben (14) und Lesen (13) von Indizes des Speichers (12) erneut initiiert werden, wenn keine Übertragung erfolgt oder wenn nur Nullen übertragen werden.

3. Verfahren nach Anspruch 1, wobei nach einem ersten Schreiben (14) in den Speicher (12) das Lesen (13) sofort gestartet wird, wenn die Schreibgeschwindigkeit größer als die Lesegeschwindigkeit ist.

4. Verfahren nach Anspruch 1, wobei eine bestimmte Anzahl von Abtastwerten in den Speicher (12) geschrieben (14) wird, bevor mit dem Lesen (13) begonnen wird, wenn die Schreibgeschwindigkeit geringer ist als die Lesegeschwindigkeit, wobei die Anzahl der Abtastwerte berechnet wird aus einem angewandten Neuabtastungs-Faktor und einer Dauer der Übertragung.

5. Verfahren nach Anspruch 1, wobei eine Größe des Speichers (12) aus einer maximalen Übertragungszeit und dem maximalen Neuabtastungs-Faktor berechnet wird.

6. Verfahren nach Anspruch 1, wobei vor dem Neuabtasten (16) eine weitere Interpolation (22) mit einer ganze Zahl M durchgeführt wird, und wobei die ausgegebenen Abtastwerte des Neuabtastens um die ganze Zahl M dezimiert werden (24).

7. Kommunikationssystem mit Mitteln, die dazu eingerichtet sind das Verfahren nach Anspruch 1 durchzuführen.

8. Kommunikationssystem nach Anspruch 7, das ferner dazu eingerichtet ist das Verfahren nach einem der Ansprüche 2 bis 6 durchzuführen.

## Revendications

1. Procédé pour corriger une erreur entre une fréquence d'échantillonnage à la transmission et une fréquence d'échantillonnage à la réception d'un signal numérique dans un système de télécommunication, dans lequel le signal numérique est traité dans le domaine temporel, le procédé comprenant les étapes suivantes au niveau de la transmission:
réception d'un signal numérique comprenant des échantillons avec une fréquence d'échantillonnage;
rééchantillonnage (18) du signal numérique pour obtenir un signal rééchantillonné, dans lequel une fréquence du signal rééchantillonné est différente de la fréquence d'échantillonnage, dans lequel le signal numérique est en bande de base, et dans lequel le ré échantillonnage est utilisé pour une correction, dans lequel la correction est une correction d'une erreur entre la fréquence d'échantillonnage à la réception et la fréquence d'échantillonnage à la transmission;
écriture (12) des échantillons de sortie provenant du rééchantillonnage dans une mémoire, dans lequel une vitesse d'écriture dans la mémoire est variable, et dans lequel une vitesse de lecture de la mémoire est fixée;
interpoler (10) du signal rééchantillonné stocké à partir de la mémoire par un nombre entier N afin d'incrémenter la fréquence d'échantillonnage;
traduction (20) du signal interpolé en bande passante, la translation comprenant l'exécution d'un ajustement à une fréquence de translation, la translation étant effectuée en multipliant des échantillons du signal interpolé par un sinus et un cosinus d'un angle, et dans lequel le réglage de la fréquence de translation est effectuée en faisant varier un incrément de l'angle via un ordinateur numérique à rotation de coordonnées, CORDIC; et
conversion (11) du signal passe-bande en un signal analogique par un convertisseur numérique-analogique, CNA,
dans lequel un bloc de correction de transmission (18) détermine la correction à appliquer au rééchantillonnage et à la translation, et dans lequel le bloc de correction de transmission fait varier la fréquence de translation via le CORDIC.

2. Procédé selon la revendication 1, dans lequel les index d'écriture (14) et de lecture (13) de la mémoire (12) sont réinitialisés lorsqu'il n'y a pas de transmission ou lorsque seulement des zéros sont transmis.

3. Procédé selon la revendication 1, dans lequel, à la suite d'une première écriture (14) dans la mémoire (12), la lecture (13) démarre immédiatement lorsque la vitesse d'écriture est supérieure à la vitesse de lecture.

4. Procédé selon la revendication 1, dans lequel un certain nombre d'échantillons sont écrits (14) dans la mémoire (12) avant de commencer à les lire (13) lorsque la vitesse d'écriture est inférieure à la vitesse de lecture, ledit nombre d'échantillons étant calculé à partir d'un facteur de rééchantillonnage appliqué et une durée de la transmission.

5. Procédé selon la revendication 1, dans lequel une taille de la mémoire (12) est calculée à partir d'un temps de transmission maximal et le facteur de rééchantillonnage maximal.

6. Procédé selon la revendication 1, dans lequel une autre interpolation (22) est effectuée par un nombre entier M avant le rééchantillonnage (18), et dans lequel les échantillons de sortie du rééchantillonnage sont décimés (24) par le nombre entier M.

7. Système de communication comprenant des moyens configurés pour exécuter le procédé selon la revendication 1.

8. Système de communication selon la revendication 7, configuré en outre pour exécuter le procédé de toute l'une des revendications 2 à 6
